# FASCICULE DE BREVET EUROPEEN

(11) **EP 0 592 293 B1**
(45) Date de publication et mention de la délivrance du brevet: **18.06.1997**
(21) Numéro de dépôt: 93402428.2
(22) Date de dépôt: 04.10.1993
(51) Int. Cl.: H04B 10/14, H01S 3/025, H04B 10/155

(54) **Tête laser perfectionnée**
Verbesserter Laserkopf
Improved laser head

(30) Priorité: 05.10.1992 FR 9211756
(43) Date de publication de la demande: 13.04.1994
(73) Titulaire: FRANCE TELECOM, 75015 Paris (FR)
(72) Inventeur: Mathoorasing, Dean, F-92130 Issy-les-Moulineaux (FR)
(74) Mandataire: Schrimpf, Robert

(56) Documents cités:
- WO-A-87/02834
- US-A- 4 834 491
- IEEE TRANSACTIONS ON MICROWAVE THEORY AND TECHNIQUES vol. 38, no. 5 , Mai 1990 , NEW YORK US pages 518 - 523 J.SCHLAFER ET AL 'Microwave Packaging of Optoelectronic Components'
- PATENT ABSTRACTS OF JAPAN vol. 15, no. 367 (E-1112)17 Septembre 1991 & JP-A-31 045 177 (TOSHIBA)

## Description

La présente invention concerne les télécommunications optiques et plus particulièrement une tête laser comprenant une diode laser, propre à convertir un signal électrique à haut débit de données en un signal optique et un dispositif de connexion en vue de relier électriquement la diode laser à une ligne d'alimentation électrique externe véhiculant ce signal électrique.

Les diodes lasers présentent une impédance faible, de l'ordre de quelques Ohms, tandis que les lignes d'alimentation électrique externes utilisées pour acheminer un signal électrique vers les diodes lasers sont généralement d'impédance plus élevée, typiquement de 50 Ohms.

Afin de limiter les pertes par réflexion dues à ces différentes valeurs d'impédance lors de la transmission du signal depuis la ligne d'alimentation électrique externe vers la diode laser, il convient d'adapter l'impédance de la diode laser et de la ligne d'alimentation électrique externe. Classiquement, cette adaptation d'impédance se fait au moyen d'un dispositif de connexion comprenant une résistance déposée en couche mince sur un substrat sur lequel est également disposée la diode laser, cette résistance étant connectée électriquement en série entre un conducteur de la ligne d'alimentation électrique externe et une électrode de la diode laser. Il est usuellement prévu en outre un té de polarisation comprenant une capacité de découplage et une inductance pour l'alimentation de la diode laser en courant de polarisation. Le substrat, la résistance, la diode laser et le té de polarisation sont habituellement montés dans un boîtier métallique constituant un blindage, muni d'un connecteur externe pour le raccordement à la ligne d'alimentation électrique externe et d'un passage pour recevoir une fibre optique couplée optiquement avec la diode laser. Le boîtier muni des éléments précités constitue ce que l'homme du métier appelle une tête laser.

Une tête laser de ce type n'offre toutefois pas entière satisfaction car la résistance déposée en couche mince présente une capacité et une inductance parasites qui introduisent une distorsion du signal véhiculé par la ligne d'alimentation électrique externe, en particulier lorsque celui-ci est un signal binaire à très haut débit de données, typiquement supérieur à 10 Gbits/s. Par ailleurs, la résistance étant déposée sur le substrat, celle-ci interdit de monter sur le substrat des diodes laser du type à rétro-action répartie (DFB, DBR), particulièrement sensibles à la température, car l'échauffement local du substrat suite à la dissipation électrique dans la résistance en couche mince rendrait le fonctionnement du laser instable.

On a proposé pour pallier ces inconvénients de modifier progressivement la géométrie de la ligne d'alimentation électrique externe afin de réaliser une variation continue d'impédance le long de celle-ci jusqu'à l'adapter à l'impédance de la diode laser. Toutefois, bien qu'une telle solution supprime les problèmes d'échauffement du substrat, elle entraîne des pertes par rayonnement importantes et présente une bande passante réduite, mal adaptée au domaine de fréquence couvert par un signal binaire à haut débit de données.

La présente invention a pour objet de remédier aux inconvénients précités des têtes laser selon l'art antérieur, en particulier vise à proposer une tête laser perfectionnée comprenant un dispositif de connexion permettant la transmission avec une faible distorsion d'un haut débit de données binaires, et qui soit en outre simple et peu coûteux.

On connaît déjà par le document :

"Microwave Packaging of Optoelectronic Components", John Schlafer et Robert B. Lauer, IEEE Transactions on Microwave Theory and Techniques, Vol. 38, No. 5, May 1990,
un système d'émission laser comprenant une tête laser qui comprend une diode laser propre à convertir un signal électrique à haut débit de données en un signal optique et un dispositif de connexion conçu pour relier électriquement la diode laser à une ligne d'alimentation électrique externe acheminant ledit signal électrique, ledit dispositif de connexion comprenant une plaquette de circuit imprimé sur laquelle sont réalisées deux pistes conductrices disjointes, la diode laser étant montée sur ladite plaquette et connectée électriquement en série avec les pistes conductrices, la plaquette étant disposée à l'intérieur d'un boîtier métallique à l'extérieur duquel sont montés deux connecteurs, respectivement reliés électriquement aux pistes conductrices, un premier de ces connecteurs servant au raccordement de la tête laser avec une ligne d'alimentation électrique externe.

L'invention propose quant à elle un système d'émission laser de ce type caractérisé en ce que le deuxième connecteur est raccordé à une charge externe d'adaptation dont l'impédance est choisie de sorte que l'impédance de la tête laser, vue à l'entrée du premier connecteur est sensiblement égale à l'impédance de la ligne d'alimentation électrique externe.

Dans une réalisation préférée de l'invention, les pistes conductrices présentent des parties rectilignes s'étendant à partir de bords opposés de la plaquette, en alignement l'une de l'autre et parallèlement, de façon espacée, à un troisième bord reliant ces bords opposés, et sont prolongées transversalement par des segments s'étendant jusqu'au troisième bord, la diode laser étant connectée électriquement à ces segments, les deux pistes conductrices étant interrompues sur leur partie rectiligne pour permettre la connexion en série avec chaque piste conductrice d'une capacité de découplage, la plaquette présentant en outre deux paires de pastilles conductrices, l'une des pastilles de chaque paire étant reliée à la portion de piste conductrice rectiligne s'étendant entre ladite interruption et le segment prolongeant cette partie rectiligne, et l'autre servant au raccordement à une ligne d'alimentation en courant de polarisation de la diode laser, une inductance reliant électriquement les deux pastilles de chaque paire.

Avantageusement, lesdites pastilles conductrices sont reliées respectivement à la portion rectiligne de piste conductrice et à un fil conducteur d'alimentation en courant de polarisation par l'intermédiaire de pistes conductrices étroites formant obstacle aux courants haute fréquence.

D'autres caractéristiques et avantages de la présente invention apparaîtront à la lecture de la description détaillée qui va suivre, d'un exemple de réalisation non limitatif de l'invention, et à l'examen du dessin annexé sur lequel :
- la figure 1 est une vue de dessus schématique d'une tête laser conforme à l'invention,
- la figure 2 est une représentation schématique montrant la disposition des pistes conductrices et de différents composants sur une plaquette de circuit imprimé,
- la figure 3 est une mesure du taux de réflexion en fonction de la fréquence d'une tête laser conforme à l'invention.

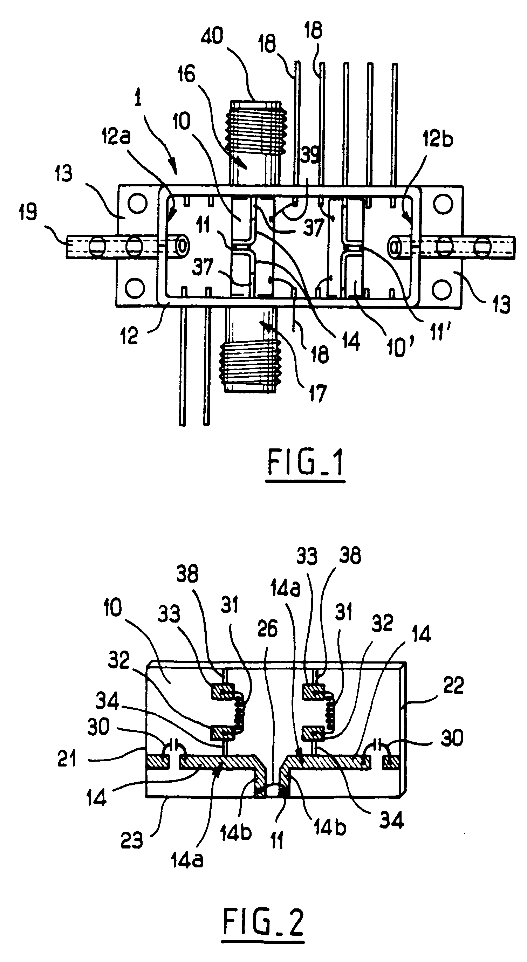

On a représenté sur la figure 1 une tête laser 1 conforme à l'invention. Cette tête laser 1 comprend une diode laser 11 montée sur une plaquette de circuit imprimé 10 placée à l'intérieur d'un boîtier métallique 12. La plaquette de circuit imprimé 10 présente une forme rectangulaire, la diode étant disposée à mi-longueur au bord d'un côté longitudinal de la plaquette, une des faces émettrices de la diode laser étant orientée vers l'extérieur de la plaquette. Le boîtier 12 présente une forme générale parallélipipédique allongée et la plaquette 10 s'étend entre deux faces longitudinales du boîtier de sorte que la face de sortie de la diode laser se situe en regard d'une face latérale 12a du boîtier. Un passage est prévu sur cette face latérale 12a pour permettre à une fibre optique externe de pénétrer à l'intérieur du boîtier en vue de son couplage optique avec la diode laser. Plus précisément, la fibre optique est enfilée dans un manchon 19 fixé au boîtier et pénétrant à l'intérieur de celui-ci, sensiblement perpendiculairement au plan de la face latérale 12a. Des pattes de fixation 13 sont prévues latéralement de part et d'autre du boîtier 12 pour sa fixation sur un support non représenté.

La plaquette de circuit imprimé 10 est réalisée par gravure d'une couche conductrice (de préférence de l'or), déposée sur une face d'un substrat en matériau diélectrique, avantageusement du nitrure d'aluminium présentant une bonne conductivité thermique et une permititivité diélectrique relative élevée (Er = 8,8).

Conformément à l'invention, deux pistes conductrices disjointes 14 sont réalisées sur une face de la plaquette 10, et la diode laser 11 relie électriquement en série ces deux pistes conductrices. L'autre face de la plaquette de circuit imprimé 10 est de préférence recouverte d'une couche conductrice servant de plan de masse et communiquant électriquement avec le boîtier lorsque la plaquette est montée dans celui-ci.

Conformément à l'invention, le boîtier 12 est muni extérieurement de connecteurs 16 et 17. L'un de ces connecteurs sert au raccordement à une ligne d'alimentation électrique externe, connue en elle-même et non représentée, véhiculant un signal électrique à convertir en signal lumineux, et l'autre connecteur sert soit au raccordement d'une charge externe connue en elle-même et non représentée, soit au raccordement d'une autre ligne d'alimentation électrique externe comme cela sera précisé dans la suite.

Les connecteurs 16 et 17, connus en eux-mêmes, comportent un corps tubulaire métallique fileté extérieurement 40, servant au raccordement électrique à une gaine de câble coaxial, relié électriquement au boîtier, et sont munis intérieurement d'une broche centrale 37 pour le raccordement à l'âme dudit câble coaxial. Les broches centrales 37 des connecteurs 16 et 17 se prolongent à l'intérieur du boîtier 12 à la faveur de perçages non représentés et se raccordent chacune à une piste conductrice 14. Les connecteurs employés sont choisis en fonction du domaine de fréquence considéré pour le signal électrique véhiculé par la ligne d'alimentation électrique externe. Il s'agit par exemple de connecteurs commercialisés par la firme RADIALL et de types connus sous la référence "SMA".

Le boîtier 12 comporte extérieurement des broches de connexion 18, isolées électriquement du boîtier, dont la fonction sera expliquée dans la suite.

Une tête laser 1 conforme à l'invention n'est pas limitée à une seule diode laser par boîtier. On peut proposer, sans sortir du cadre de l'invention, de disposer à l'intérieur du boîtier 12 une deuxième plaquette de circuit imprimé 10', la face de sortie de la diode laser 11' de cette plaquette 10' étant alors tournée vers la face 12b du boîtier 12 opposée à la face 12a et un passage pour une fibre optique étant prévu sur cette face latérale opposée 12b. L'alimentation électrique de cette deuxième diode laser 11' se fait, au choix de l'homme du métier, conformément à l'invention à l'aide de connecteurs semblables aux connecteurs 16 et 17 et non représentés, soit à l'aide de broches 18.

On a représenté plus précisément, isolément, une plaquette de circuit imprimé 10 sur la figure 2. De préférence, comme représenté, les pistes conductrices 14 présentent des parties rectilignes 14a s'étendant depuis des bords latéraux opposés 21, 22 de la plaquette, parallèlement à un bord longitudinal 23 reliant les deux bords latéraux et de façon espacée à celui-ci, en alignement l'une de l'autre. Ces parties rectilignes 14a sont prolongées, transversalement, à leurs extrémités proches, par des segments 14b s'étendant jusqu'au bord 23 et à l'extrémité libre desquels est montée la diode laser 11. La plaquette 10 est montée dans le boîtier 12 en positionnant les parties rectilignes 14a dans le prolongement des broches 37 des connecteurs 16 et 17, de façon à minimiser la longueur de connexion entre les broches 37 et les extrémités des parties rectilignes 14a débouchant sur les bords latéraux 21 et 22, donc les pertes par rayonnement.

Les pistes 14 présentent sur toute leur longueur une largeur constante, avantageusement comprise entre 250 et 350 µm, de préférence voisine de 300 µm, à l'exception du coude formé par la partie rectiligne 14a et le segment transversal 14b, dont l'angle saillant est biseauté. La diode laser 11 est collée, par exemple à l'aide d'une goutte d'Indium, sur l'un des segments transversaux 14b, sa face de sortie optique affleurant avec le bord longitudinal 23 de la plaquette, le collage assurant la connexion électrique entre une électrode de la diode et le segment sur lequel elle est collée, l'autre électrode de la diode étant reliée au moyen d'un fil conducteur, de préférence en or, à l'autre segment. L'espacement entre les parties rectilignes 14a et le bord longitudinal 23 de la plaquette (correspondant à la longueur des segments 14b) doit être suffisant pour isoler correctement les pistes conductrices 14 de la face métallisée opposée de la plaquette, servant de plan de masse, mais les segments 14b doivent cependant être d'une longueur suffisamment réduite pour ne pas entraîner de pertes par couplage radioélectrique entre eux.

Avantageusement, les parties rectilignes 14a sont espacées de 300 µm du bord 23 et les deux segments 14b sont espacés entre eux d'une distance, comprise entre 75 et 125 µm, de préférence 100 µm.

Les pistes conductrices 14 sont interrompues sur leurs parties rectilignes 14a pour permettre la connexion en série sur chacune des parties 14a, d'un condensateur de découplage 30. L'alimentation de la diode laser 11 en courant de polarisation se fait au moyen de deux inductances 31, électriquement reliées par une borne à la portion des parties rectilignes 14a s'étendant entre le condensateur de découplage 30 et le segment 14b, et par l'autre borne à une broche de connexion 18 précitée. Plus précisément, les inductances 31 sont chacune soudées sur une paire de pastilles conductrices 32 et 33 réalisées par gravure de la couche conductrice déposée sur le substrat, l'une des pastilles 32 de chaque paire étant électriquement reliée à la portion de piste conductrice 14a par une étroite piste 34 de moindre largeur que les pistes conductrices 14, formant obstacle aux hautes fréquences, l'autre pastille 33 étant reliée à un fil conducteur connecté à la broche 18 par une autre étroite piste 38 de moindre largeur que les pistes conductrices 14. Les valeurs des capacités de découpage 30 et des inductances 31 sont aisément choisies par l'homme de métier en fonction du domaine de fréquence couvert par le signal électrique provenant de la ligne externe.

Comme dit plus haut, l'un des connecteurs, celui désigné par exemple sous la référence 17, est apte à recevoir une charge externe dont l'impédance est choisie pour adapter l'impédance de la tête laser, vue à l'entrée de l'autre connecteur 16, à l'impédance de la ligne d'alimentation électrique externe. Il est à noter ici que l'impédance de la diode laser est faible par rapport à l'impédance de la ligne d'alimentation électrique externe.

Il convient de préciser que les condensateurs et les inductances précités permettent notamment d'éviter que la charge ne soit parcourue par un courant continu et ainsi s'échauffe. Cette charge externe, connue en elle-même, présente une impédance constante sur une large plage de fréquence. Celle-ci est avantageusement constituée par une couronne en matériau diélectrique tel que du polytétrafluoréthylène disposée entre deux armatures conductrices cylindriques de révolution. Il s'agit par exemple d'une charge coaxiale miniature telle que commercialisée par la firme RADIALL sous la référence R 404 280, venant s'emboîter dans les connecteurs "SMA" précités, les deux armatures précitées contactant électriquement respectivement la broche centrale 37 et le corps externe 40 du connecteur 17.

Avantageusement, la tête laser conforme à l'invention permet en variante la connexion du connecteur 17 à une deuxième ligne d'alimentation électrique externe afin de réaliser une intermodulation. Plus précisément, on alimente dans ce cas la diode laser 11 à l'aide de deux lignes d'alimentation électrique externes connectées respectivement aux connecteurs 16 et 17 de la tête laser, par deux signaux de fréquences différentes f₁ et f₂ et l'on observe la réponse de la diode laser à ces signaux, de façon à en caractériser la non-linéarité, notamment par l'observation des harmoniques 2f₁ et 2f₂, ainsi que 2f₂-f₁ et 2f₁-f₂.

Ainsi, grâce à l'invention, on peut facilement déterminer les caractéristiques de linéarité d'un laser alors que dans les têtes laser connues ne disposant que d'un seul connecteur, l'intermodulation s'effectue au travers d'un dispositif de couplage complexe et coûteux. Avantageusement, des moyens de régulation thermique peuvent être montés à l'intérieur du boîtier 12. Il s'agit de préférence d'un refroidisseur à effet Peltier, connu en lui-même, monté sur la face de la plaquette de circuit imprimé opposée aux pistes conductrices 14.

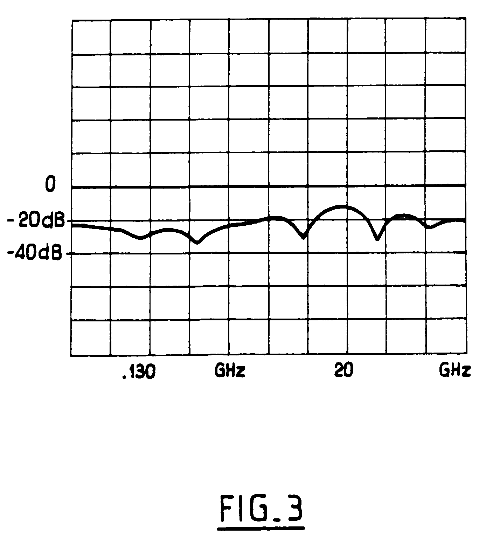

Finalement, une tête laser conforme à l'invention permet de transmettre un très grand débit de données binaires avec peu de distorsions et avec un faible taux de réflexion entre la ligne d'alimentation électrique externe et la tête laser. On peut ainsi obtenir, comme le montre la figure 3 un taux de réflexion meilleur que - 14 dB sur la plage de fréquence allant de 130 MHz à 20 GHz. La qualité de la tête laser en mode impulsionnel apparaîtra pour les spécialistes à l'observation d'un diagramme de l'oeil de la tête laser.

## Revendications

1. Système d'émission laser comprenant une tête laser qui comprend une diode laser (11) propre à convertir un signal électrique à haut débit de données en un signal optique et un dispositif de connexion conçu pour relier électriquement la diode laser à une ligne d'alimentation électrique externe acheminant ledit signal électrique, ledit dispositif de connexion comprenant une plaquette de circuit imprimé (10) sur laquelle sont réalisées deux pistes conductrices disjointes (14), la diode laser étant montée sur ladite plaquette et connectée électriquement en série avec les pistes conductrices, la plaquette étant disposée à l'intérieur d'un boîtier métallique (12) à l'extérieur duquel sont montés deux connecteurs (16,17), respectivement reliés électriquement aux pistes conductrices, un premier de ces connecteurs servant au raccordement de la tête laser avec une ligne d'alimentation électrique externe, caractérisé en ce que le deuxième connecteur est raccordé à une charge externe d'adaptation dont l'impédance est choisie de sorte que l'impédance de la tête laser, vue à l'entrée du premier connecteur est sensiblement égale à l'impédance de la ligne d'alimentation électrique externe.

2. Système d'émission laser selon la revendication 1, caractérisé en ce que les pistes conductrices (14) présentent des parties rectilignes (14a) s'étendant à partir de bords opposés (21, 22) de la plaquette (10), en alignement l'une de l'autre et parallèlement, de façon espacée, à un troisième bord (23) de la plaquette reliant ces bords opposés, et sont prolongées transversalement par des segments (14b) s'étendant jusqu'au troisième bord, la diode laser (11) étant connectée électriquement à ces segments, les deux pistes conductrices étant interrompues sur leur partie rectiligne pour permettre la connexion en série avec chaque piste d'une capacité de découplage (30), la plaquette de substrat présentant en outre deux paires de pastilles conductrices (32, 33), l'une (32) des pastilles de chaque paire étant reliée à la portion de piste conductrice rectiligne (14a) s'étendant entre ladite interruption et le segment prolongeant cette partie rectiligne, et l'autre (33) servant au raccordement à une ligne d'alimentation en courant de polarisation de la diode laser, une inductance (31) reliant électriquement les deux pastilles de chaque paire.

3. Système d'émission laser selon la revendication 2, caractérisé en ce que lesdites pastilles conductrices (32, 33) sont reliées respectivement à la portion rectiligne (14a) de piste conductrice (14) et à un fil conducteur (39) d'alimentation en courant de polarisation par l'intermédiaire de pistes conductrices étroites (34, 38) formant obstacle aux courants haute fréquence.

4. Système d'émission laser selon la revendication 2 ou 3, caractérisé en ce que lesdites parties coudées sont espacées l'une de l'autre d'une distance comprise entre 75 et 125 µm.

5. Système d'émission laser selon l'une des revendications 1 à 4, caractérisé en ce que la plaquette de circuit imprimé est constituée d'un substrat en nitrure d'aluminium sur lequel sont réalisées lesdites pistes conductrices par gravure d'une couche conductrice déposée sur ce substrat.

6. Système d'émission laser selon l'une des revendications 1 à 5, caractérisé en ce que lesdites pistes conductrices (14) présentent une largeur comprise entre 250 et 350 µm.

## Patentansprüche

1. Laseremissionssystem mit einem Laserkopf, der eine Laserdiode (11), die dazu geeignet ist, ein elektrisches Signal von hoher Datenrate in ein optisches Signal umzuwandeln, und eine Verbindungseinrichtung aufweist, die so ausgebildet ist, daß sie die Laserdiode elektrisch mit einer externen elektrischen Speiseleitung verbindet, die das elektrische Signal befördert wobei die Verbindungseinrichtung eine gedruckte Schaltungsplatte (10) ausweist, auf der zwei getrennte Leiterbahnen (14) ausgebildet sind, wobei die Laserdiode auf der Platte angebracht und elektrisch in Reihe mit den Leiterbahnen verbunden ist, wobei die Platte im Inneren eines metallischen Gehäuses (12) angeordnet ist, an dessem Äußeren zwei Stecker (16, 17) angebracht sind, die jeweils elektrisch mit den Leiterbahnen verbunden sind, wobei ein erster dieser Stecker dazu dient, den Laserkopf mit einer externen elektrischen Speiseleitung zu verbinden, dadurch **gekennzeichnet,** daß der zweite Stecker an eine externe Anpassungslast angeschlossen ist, deren Impedanz so gewählt ist, daß die Impedanz des Laserkopfes, die am Eingang des ersten Steckers gesehen wird, im wesentlichen so groß wie die Impedanz der externen elektrischen Speiseleitung ist.

2. Laseremissionssystem nach Anspruch 1, dadurch **gekennzeichnet,** daß die Leiterbahnen (14) geradlinige Teile (14a) aufweisen, die sich ausgehend von gegenüberliegenden Kanten (21, 22) der Platte (10) derart erstrecken, daß sie miteinander fluchten und parallel in Abstand zu einer dritten, diese gegenüberliegenden Kanten verbindenden Kante (23) der Platte liegen, und die in Querrichtung durch Segmente (14b) verlängert werden, die sich bis zu der dritten Kante erstrecken, wobei die Laserdiode (11) elektrisch mit diesen Segmenten verbunden ist, wobei die beiden Leiterbahnen auf ihrem geradlinigen Teil unterbrochen sind, um die elektrische Reihenschaltung einer Entkoppelkapazität (30) mit jeder Bahn zu ermöglichen, wobei die Substratplatte des weiteren zwei Paare von leitfähigen Pillen (32, 33) aufweist, wobei die eine (32) der Pillen jedes Paares mit dem geradlinigen Teil (14a) der Leiterbahn, der sich zwischen der Unterbrechung und dem diesen geradlinigen Teil verlängernden Segment erstreckt, verbunden ist und die andere (33) zum Anschluß an eine Speiseleitung für den Polarisationsstrom der Laserdiode dient, wobei eine Induktivität (31) elektrisch die beiden Pillen jedes Paares verbindet.

3. Laseremissionssystem nach Anspruch 2, dadurch **gekennzeichnet,** daß die Leiterpillen (32, 33) mit Hilfe von schmalen Leiterbahnen (34, 38), die ein Hindernis für die hochfrequenten Ströme bilden, jeweils mit dem geradlinigen Teil (14a) der Leiterbahn (14) und mit einem leitfähigen Zuführungsdraht (39) für den Polarisationsstrom verbunden sind.

4. Laseremissionssystem nach Anspruch 2 oder 3, dadurch **gekennzeichnet,** daß die abgewinkelten Teile in einem Abstand zwischen 75 und 125 µm voneinander angeordnet sind.

5. Laseremissionssystem nach einem der Ansprüche 1 bis 4, dadurch **gekennzeichnet,** daß die gedruckte Schaltungsplatte durch ein Substrat aus Aluminiumnitrid gebildet wird, auf dem die Leiterbahnen durch Ätzen einer auf diesem Substrat abgelagerten leitfähigen Schicht ausgebildet sind.

6. Laseremissionssystem nach einem der Ansprüche 1 bis 5, dadurch **gekennzeichnet,** daß die Leiterbahnen (14) eine Breite zwischen 250 und 350 µm aufweisen.

## Claims

1. A laser emitting system including a laser head which comprises a laser diode (11) suitable for converting a high data rate electrical signal into an optical signal, and a connection device designed to connect the laser diode electrically to an external electrical feed line conveying said electrical signal, said connection device comprising a printed circuit card (10) on which two disjoint conductive tracks (14) are formed, the laser diode being mounted on said card and being electrically connected in series with the conductive tracks, the card being disposed inside a metal box (12) on the outside of which two connectors (16, 17) are mounted which are electrically connected to respective ones of the conductor tracks, a first one of said connectors serving for connecting the laser head to an external electrical feed line, the system being characterized in that the second one of said connectors is connected to an external impedance-matching load selected so that the impedance of the laser diode as seen at the inlet to the first connector is substantially equal to the impedance of the external electrical feed line.

2. A laser emitting system according to claim 1, characterized in that the conductor tracks (14) have respective rectilinear portions (14a) extending from opposite edges (21, 22) of the card (10), that are in alignment with each other, and that are parallel and spaced apart from a third edge (23) of the card interconnecting said opposite edges, said rectilinear portions being extended transversely by segments (14b) that extend to said third edge, the laser diode (11) being electrically connected to said segments, the two conductive tracks being interrupted in their rectilinear portions so as to enable a respective decoupling capacitor (30) to be connected in series with each track, the printed circuit card further presenting two pairs of conductive tabs (32, 33), one of the tabs (32) in each pair being connected to a respective portion of rectilinear conductive track (14a) between said interruption and the segment transversely extending said rectilinear portion, and the other tab (33) in each pair serving for connection to a line for feeding bias current to the laser diode, an inductor (31) being electrically connected between the two tabs of each pair.

3. A laser emitting system according to claim 2, characterized in that said conductive tabs (32, 33) are connected respectively to the corresponding rectilinear portion (14a) of the conductive track (14) and to a bias current feed conductor wire (39) via narrow conductive tracks (34, 38) that constitute obstacles to high frequency currents.

4. A laser emitting system according to claim 2 or 3, characterized in that said segments (14b) are spaced apart from each other by a distance lying in the range 75 µm to 125 µm.

5. A laser emitting system according to any one of claims 1 to 4, characterized in that the printed circuit card is constituted by a substrate of aluminum nitride on which said conductive tracks are implemented by etching a conductive layer deposited on said substrate.

6. A laser emitting system according to any one of claims 1 to 5, characterized in that the width of said conductive tracks (14) lies in the range 250 µm to 350 µm.
